# EUROPEAN PATENT APPLICATION

(11) **EP 4 485 024 A1**
(43) Date of publication of application: **01.01.2025**
(21) Application number: 23759847.9
(22) Date of filing: 16.02.2023
(51) Int. Cl.: G02B 6/122, G02B 6/12, G02B 6/42

(54) **OPTICAL WAVEGUIDE SUBSTRATE, OPTICAL WAVEGUIDE PACKAGE, AND LIGHT SOURCE MODULE**

(30) Priority: 25.02.2022 JP 2022028575
(71) Applicant: Kyocera Corporation, Kyoto-shi, Kyoto 612-8501 (JP)
(72) Inventor: MATSUNAGA, Shougo, Kyoto-shi, Kyoto 612-8501 (JP); ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2023/005421
(87) International publication number: WO 2023/162846

(57) **Abstract**

An optical waveguide board (6) includes a substrate (11), a cladding layer (12) on the substrate (11), and a core (17) in the cladding layer (12). The core (17) defines an optical waveguide. The cladding layer (12) includes a first surface (12a) facing the substrate (11) and a second surface (12b) opposite to the first surface (12a), and includes, on the second surface (12b), an element mount area (21) on which a light receiver (4) is mountable. The element mount area (21) is located with the core (17) between portions of the element mount area (21) in a plan view. A height from the substrate (11) to the element mount area (21) is greater than a height from the substrate (11) to an upper surface of an area of the cladding layer (12) covering the core (17).

## Description

### TECHNICAL FIELD

The present disclosure relates to an optical waveguide board, an optical waveguide package, and a light source module.

### BACKGROUND OF INVENTION

A known optical waveguide board is described in, for example, Patent Literature 1.

### CITATION LIST

### PATENT LITERATURE

Patent Literature 1: Japanese Unexamined Patent Application Publication No. 10-318765
Patent Literature 2: Japanese Unexamined Patent Application Publication No. 2021-148911

### SUMMARY

In an aspect of the present disclosure, an optical waveguide board includes a substrate, a cladding layer on the substrate, and a core in the cladding layer. The core defines an optical waveguide. The cladding layer includes a first surface facing the substrate and a second surface opposite to the first surface, and includes, on the second surface, an element mount area on which a light receiver is mountable. The element mount area is located with the core between portions of the element mount area in a plan view. A height from the substrate to the element mount area is greater than a height from the substrate to an upper surface of an area of the cladding layer covering the core.

In an aspect of the present disclosure, an optical waveguide package includes the optical waveguide board and a light receiver mounted on the element mount area. The light receiver includes a light receiving part at a position overlapping the core in a plan view.

In an aspect of the present disclosure, a light source module includes the optical waveguide package, a light emitter optically coupled to the light receiver with the core, and a lid covering the light receiver and the light emitter.

### BRIEF DESCRIPTION OF THE DRAWINGS

The objects, features, and advantages of the present disclosure will be more apparent from the following detailed description and the drawings.
FIG. 1 is a schematic perspective view of a light source module according to an embodiment of the present disclosure.
FIG. 2 is a cross-sectional view taken along section line II-II in FIG. 1.
FIG. 3 is a plan view of an optical waveguide board.
FIG. 4A is a cross-sectional view of a light receiver in the first embodiment taken along section line IV-IV in FIG. 3, illustrating its structural arrangement.
FIG. 4B is a plan view of the light receiver.
FIG. 4C is a plan view of a cladding layer.
FIG. 5A is a cross-sectional view of a light receiver in a second embodiment, illustrating its structural arrangement.
FIG. 5B is a plan view of the light receiver.
FIG. 5C is a plan view of a cladding layer.
FIG. 6A is a cross-sectional view of a light receiver in a third embodiment, illustrating its structural arrangement.
FIG. 6B is a plan view of the light receiver.
FIG. 6C is a plan view of a cladding layer.
FIG. 7A is a cross-sectional view of a light receiver in a fourth embodiment, illustrating its structural arrangement.
FIG. 7B is a plan view of the light receiver.
FIG. 7C is a plan view a cladding layer.
FIG. 8A is a cross-sectional view of a light receiver in a fifth embodiment, illustrating its structural arrangement.
FIG. 8B is a plan view of the light receiver.
FIG. 8C is a plan view of a cladding layer.
FIG. 9 is a plan view of an optical waveguide board according to a sixth embodiment, illustrating the structural arrangement of a light receiver.
FIG. 10A is a cross-sectional view taken along section line X-X in FIG. 9.
FIG. 10B is a plan view of the light receiver.
FIG. 10C is a plan view of a cladding layer.
FIG. 11A is a cross-sectional view of a light receiver in a seventh embodiment, illustrating its structural arrangement.
FIG. 11B is a plan view of the light receiver.
FIG. 11C is a plan view of a cladding layer.
FIG. 12 is a plan view of a light source module according to another embodiment.

### DESCRIPTION OF EMBODIMENTS

A known optical waveguide board includes, in a cladding layer on a substrate, cores that define optical waveguides. For example, Patent Literature 1 describes an optical waveguide board including a core layer and a cladding layer stacked on each other on a substrate, and a mount area for a light receiver that is a partially removed area in the cladding layer. Patent Literature 2 describes an optical waveguide board supporting a light receiver on a cladding layer with protrusions at the same height as cores to have a light receiving part facing upward.

In the optical waveguide board of this type, the light receiver senses a part of light traveling through the cores. The light receiver is thus to be improved to have the structural arrangement for higher light sensitivity.

An embodiment of the present disclosure will now be described with reference to the drawings.

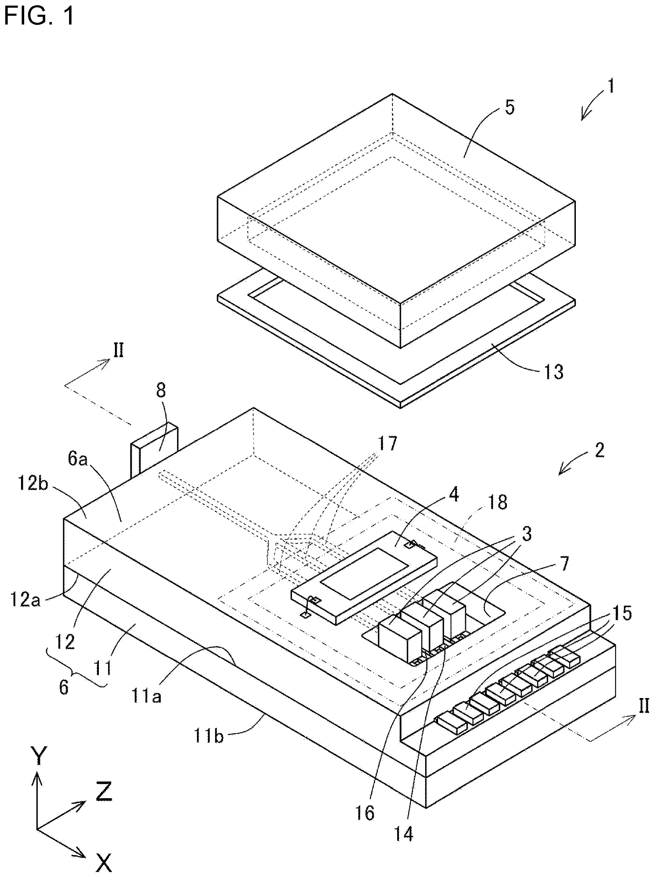

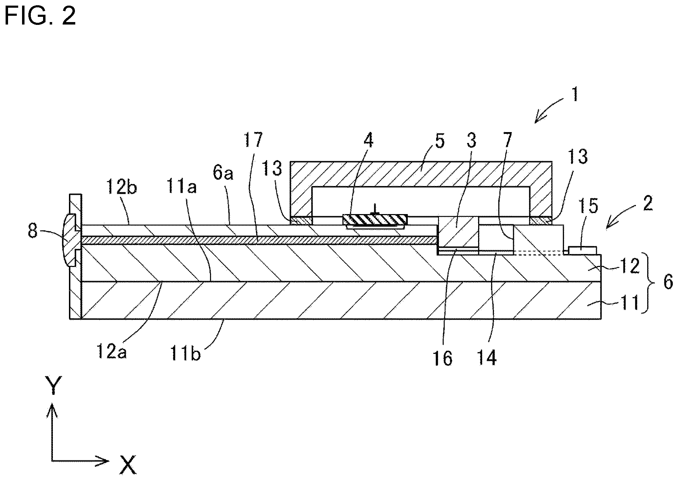

FIG. 1 is a schematic perspective view of a light source module according to an embodiment of the present disclosure. FIG. 2 is a cross-sectional view taken along section line II-II in FIG. 1. The structure of the light source module will be described first with reference to FIGs. 1 and 2. A light source module 1 according to the present embodiment includes an optical waveguide package 2, light emitters 3, a light receiver 4, and a lid 5 covering the light emitters 3 and the light receiver 4. Note that an optical waveguide board 6 is rectangular in a plan view in the orthogonal three-axis XYZ coordinate system with an X-axis indicating a length direction, a Y-axis indicating a width direction, and a Z-axis indicating a thickness direction of the optical waveguide board 6.

The optical waveguide package 2 includes the optical waveguide board 6. The optical waveguide board 6 includes an upper surface 6a including a recess 7. Three light emitters 3 are located in the recess 7. A condenser lens 8 is located at one end of the optical waveguide board 6 in the length direction. Light emitted from the light emitters 3 enters the condenser lens 8. A mirror that reflects light may be located in place of the condenser lens 8.

The optical waveguide board 6 includes a substrate 11 including multiple dielectric layers of a ceramic material or an organic material stacked on one another, and a cladding layer 12 of, for example, a glass material or a resin material. The substrate 11 includes an upper surface 11a and a lower surface 11b. The cladding layer 12 is located on the upper surface 11a of the substrate 11. For the substrate 11 including dielectric layers stacked on one another, the substrate 11 may be an organic wiring board including the dielectric layers each made of, for example, an organic material. The organic wiring board is, for example, a printed wiring board, a build-up wiring board, or a flexible wiring board. Examples of the organic material used for the organic wiring board include an epoxy resin, a polyimide resin, a polyester resin, an acryl resin, a phenolic resin, and a fluororesin.

The cladding layer 12 includes a first surface (lower surface) 12a facing the upper surface 11a of the substrate 11, and a second surface (upper surface) 12b opposite to the first surface 12a. The cladding layer 12 includes the recess 7 on the second surface 12b and multiple external connection terminals 15 on the second surface 12b at the other end in the length direction.

The light emitters 3 are bonded to wires 14 on a bottom surface of the recess 7 with a conductive bond 16, such as solder or a brazing material. Each of the light emitters 3 includes, on its lower surface, an electrode electrically connected to the corresponding wire 14 with the conductive bond 16. The wires 14 extend outside the recess 7 and are electrically connected to the respective external connection terminals 15. The external connection terminals 15 are electrically connected to an external device, such as a power supply circuit, through external wiring (not illustrated).

The cladding layer 12 contains three cores 17 that define optical waveguides. The three cores 17 extend from the recess 7 to one end of the optical waveguide board 6 in a plan view. Each of the cores 17 includes an incident end located on an inner wall of the recess 7. The incident end faces an emission surface of the corresponding light emitter 3 inside the recess 7. The three cores 17 merge with one another to form a merging portion. The three cores 17 are integrated to define a waveguide extending from the merging portion to one end of the optical waveguide board 6. Each of the cores 17 is made of a light guide material with a higher light refractive index than the cladding layer 12, such as quartz glass. Each of the cores 17 totally reflects light emitted from the corresponding light emitter 3 inside the core 17 and guides the light in the length direction (the X-direction in FIG. 1) of the optical waveguide board 6 with the light confined in the optical waveguide.

In the present embodiment, the light emitters 3 are three laser diodes (LDs) that individually emit light of three colors, or red, green, and blue. The cores 17 include the incident ends optically coupled to the respective LDs and emission ends optically coupled to the condenser lens 8. The light emitters 3 are optically coupled to the light receiver 4 with the cores 17. The light receiver 4 above the cores 17 senses light leaking from the cores 17 and outputs a predetermined signal to an external device. The light emitters 3 are not limited to LDs, but may be, for example, light-emitting diodes (LEDs) or vertical-cavity surface-emitting lasers (VCSELs).

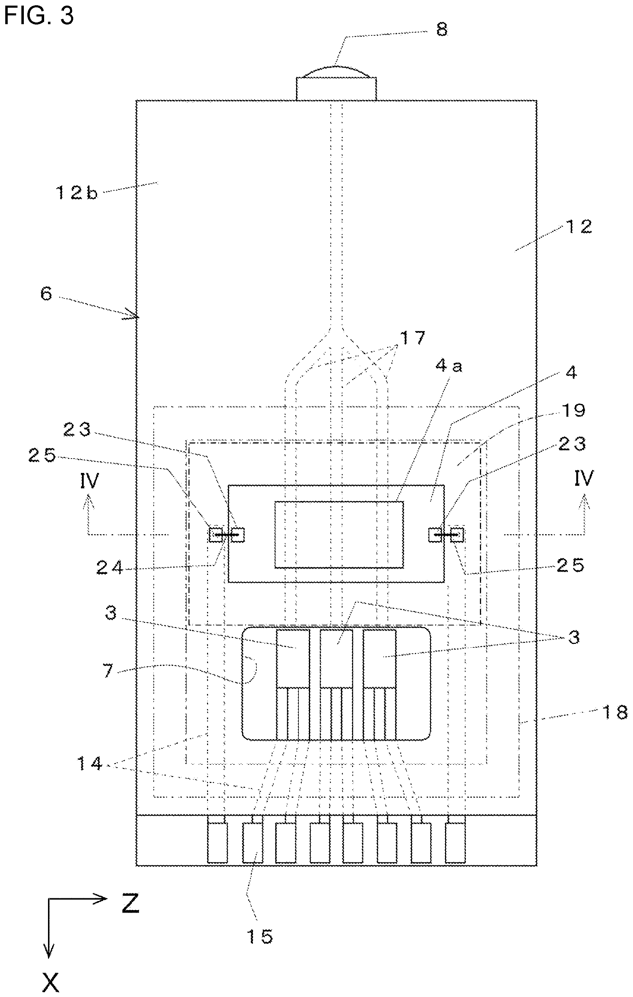

The structural arrangement of the light receiver 4 will now be described. FIG. 3 is a plan view of the optical waveguide board 6. In the optical waveguide board 6 illustrated in FIG. 3, the light receiver 4 is located on the second surface 12b of the cladding layer 12, and a joint area 18 (indicated by a two-dot-dash line) for bonding the lid 5 is defined on the second surface 12b of the cladding layer 12.

The lid 5 is a thin box made of, for example, glass, and includes an opening in a lower surface. The lid 5 is bonded to the cladding layer 12 with a bond 13 (refer to FIG. 2), such as solder or a paste. The joint area 18 is defined as a quadrangular frame similar to the lower surface of the lid 5. The joint area 18 includes the recess 7 receiving the light emitters 3 and an area 19 (an area defined by a dot-dash line) receiving the light receiver 4. The lid 5 is bonded to the joint area 18 to seal the light emitters 3 and the light receiver 4 within the joint area 18.

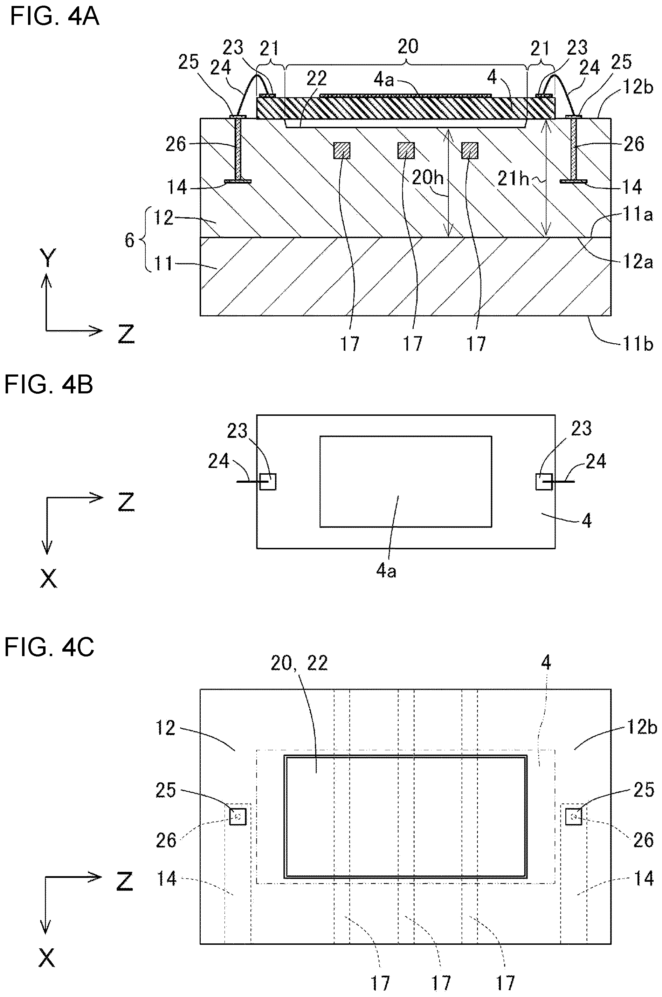

FIGs. 4A to 4C each illustrate the structural arrangement of the light receiver in the first embodiment. FIG. 4A is a cross-sectional view taken along section line IV-IV in FIG. 3. FIG. 4B is a plan view of the light receiver. FIG. 4C is a plan view of the cladding layer. In this structural arrangement of the light receiver, as illustrated in FIGs. 4A to 4C, the area 19 receiving the light receiver 4 includes a light receiving area 20 that covers the cores 17 in a plan view and an element mount area 21 on which the light receiver 4 is mountable. The second surface 12b of the cladding layer 12 includes a recess 22 in an area corresponding to the light receiving area 20. The element mount area 21 is frame-shaped to surround the recess 22.

In this structure, as illustrated in FIG. 4A, a height (21h) from the substrate 11 to the element mount area 21 is greater than a height (20h) from the substrate 11 to an upper surface of an area of the cladding layer 12 covering the cores 17. More specifically, the height 21h from the substrate 11 to the element mount area 21 is greater than the height 20h from the substrate 11 to the light receiving area 20 by a distance (21h - 20h) corresponding to the depth of the recess 22. Note that the light receiving area 20 and the element mount area 21 may have a height difference (21h - 20h) between them with the element mount area 21 protruding from the second surface 12b of the cladding layer 12. A difference Δh between the height 21h and the height 20h (= 21h - 20h) is, for example, 1 to 20 µm inclusive.

As illustrated in FIGs. 4A and 4B, the light receiver 4 includes a light receiving part 4a facing upward. The light receiver 4 includes the light receiving part 4a at a position overlapping the cores in a plan view. This facilitates sensing of light leaking from the cores 17. The light receiver 4 may be, for example, a photodiode (PD), a complementary metal-oxide semiconductor (CMOS), or a charge-coupled device (CCD). A pair of electrodes 23 are arranged adjacent to the light receiving part 4a. The electrodes 23 are electrically connected to respective electrodes 25 on the cladding layer 12 with bonding wires 24. Each of the electrodes 25 is electrically connected to the corresponding wire 14 in the cladding layer 12 through a feedthrough conductor 26, or also referred to as a via hole.

In this structural arrangement of the light receiver, the element mount area 21 has the height 21h greater than the height 20h of the light receiving area 20. This structure reliably leaves a gap of 21h - 20h between the cladding layer 12 and the light receiver 4, avoiding contact between the light receiver 4 and the cladding layer 12. This reduces the likelihood that the light receiver 4 and the substrate 11 are rubbed against each other or the cores 17 deform when the light receiver 4 or the substrate 11 receives stress resulting from thermal deformation or an external force, thus allowing the optical waveguide board 6 to retain high optical propagation efficiency.

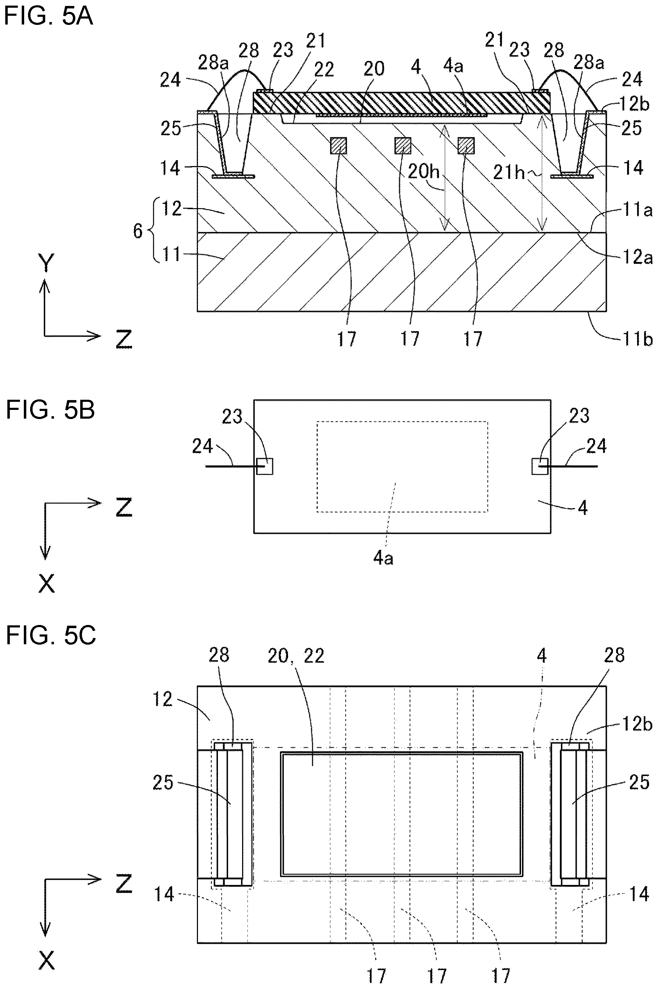

FIGs. 5 A to 5C each illustrate the structural arrangement of a light receiver in a second embodiment. FIG. 5A is a cross-sectional view. FIG. 5B is a plan view of the light receiver. FIG. 5C is a plan view of a cladding layer. Note that like reference numerals denote the corresponding parts of the structural arrangement of the light receiver in the first embodiment described above. In the structural arrangement of the light receiver in the second embodiment, as illustrated in FIGs. 5A to 5C, the light receiver 4 includes the light receiving part 4a facing downward to face the optical waveguide board 6. In other words, the light receiver 4 includes the light receiving part 4a mounted to face the optical waveguide board 6. The cladding layer 12 includes, outside the element mount area 21, first recesses 28 extending along the cores 17. The first recesses 28 are located with the three cores 17 between them in a plan view. Each of the first recesses 28 includes a side surface 28a sloping to face more upward to have its width wider at a position closer to the second surface 12b than at a position closer to the first surface 12a of the cladding layer 12.

The side surface 28a of the first recess 28 has a greater surface roughness than the second surface 12b of the cladding layer 12. Each of the electrodes 25 on the cladding layer 12 extends from the second surface 12b of the cladding layer 12 onto the side surface 28a of the corresponding first recess 28. The electrodes 25 are connected to the respective wires 14 exposed to bottom surfaces of the first recesses 28. The other components are the same as or similar to those in the first embodiment, and will not be described repeatedly.

In the structural arrangement of the light receiver in the second embodiment, the light receiving part 4a faces the cladding layer 12 in the optical waveguide board 6. The light receiver 4 thus includes the body that is not located between the light receiving part 4a and the cores 17 that transmit light. The light receiver 4 can thus sense light leaking from the cores 17 more reliably. The body of the light receiver 4 is located between the outside and the light receiving part 4a. The light receiver 4 is thus less susceptible to external light. The cladding layer 12 including the first recesses 28 thus has a buffering effect to reduce deformation of the cores 17 resulting from deformation of the optical waveguide board 6.

Additionally, in the structural arrangement of the light receiver in the second embodiment, the electrodes 25 on the cladding layer 12 extend onto the side surfaces 28a of the first recesses 28 to fully cover the side surfaces 28a. This structure effectively reduces ambient light entering the cladding layer 12. The sloping side surfaces 28a also reduce the amount of light returning to the cores 17. The electrodes 25 extend onto the bottom surfaces of the respective first recesses 28 and are connected to the respective wires 14. This structure eliminates wire bonding for connection between the electrodes 25 and the wires 14, and thus downsizes the optical waveguide board 6.

The side surfaces 28a each have a greater surface roughness than the second surface 12b of the cladding layer 12. The rough surface thus reduces diffusion of light leaking from the cores 17 and returning to the cores 17. The rough surface also produces an anchoring effect to increase the bonding strength between the rough surface and the corresponding electrode 25, and prevents the electrode 25 from separating from the side surface 28a under stress. The surface roughness herein refers to an arithmetic mean roughness Ra.

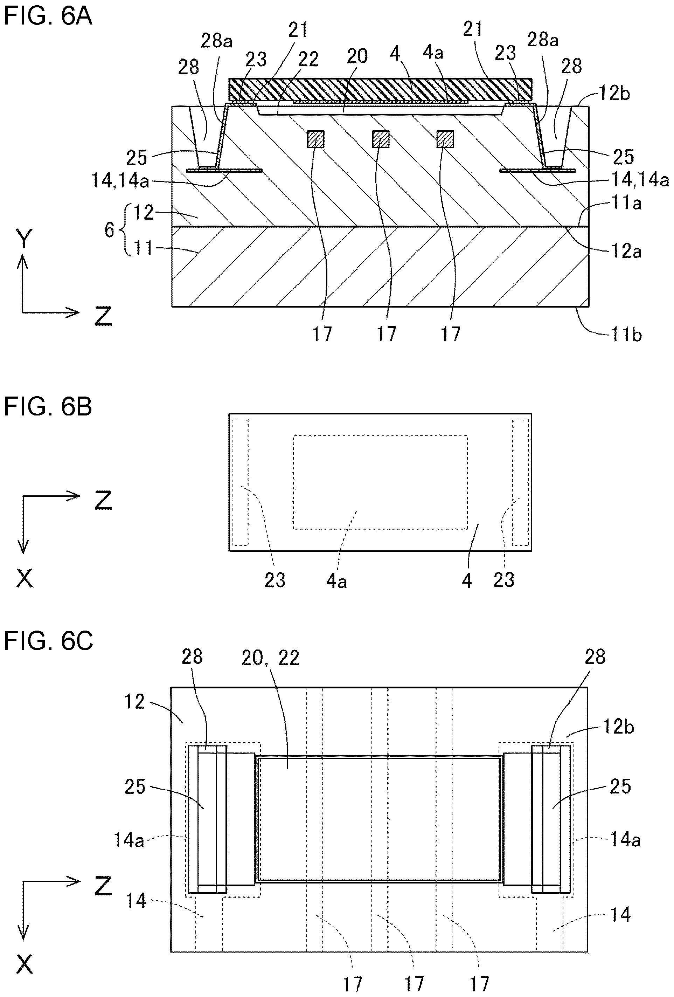

FIGs. 6A to 6C each illustrate the structural arrangement of a light receiver in a third embodiment. FIG. 6A is a cross-sectional view. FIG. 6B is a plan view of the light receiver. FIG. 6C is a plan view of a cladding layer. Note that like reference numerals denote the corresponding parts of the structural arrangement of the light receiver in the first embodiment. In the structural arrangement of the light receiver in the third embodiment, as illustrated in FIGs. 6A to 6C, the light receiver 4 is joined to the element mount area 21 at its two ends with a bond. The electrodes 25 are on the element mount area 21 on the second surface 12b of the cladding layer 12. The element mount area 21 overlaps the light receiver 4. The electrodes 23 on the light receiver 4 are electrically connected to the respective electrodes 25. Each of the electrodes 25 covering the second surface 12b of the cladding layer 12 and the side surface 28a of the corresponding first recess 28 includes a conductor having a relatively low reflectance. Each of the wires 14 exposed on the bottom surface of the corresponding first recess 28 includes a wide portion 14a with a higher light reflectance than the electrode 25. Each of the wires 14 extends to a position overlapping the element mount area 21 in a plan view. The other components are the same as or similar to those in the second embodiment. When, for example, the wires 14 are made of aluminum (Al), the electrodes 25 may be made of, for example, Ti, Cr, or Ni, as the conductors with a low reflectance.

In the structural arrangement of the light receiver in the third embodiment, the electrodes are located on the element mount area 21. Thus, the light receiving part 4a in the light receiver 4 can face the optical waveguide board 6 with the light receiving part 4a and the electrodes 23 located in the same plane, reducing the manufacturing cost. The light receiver 4 can be mounted by flip-chip connection without wire bonding. The optical waveguide board 6 can thus have a reduced height. The electrodes 25 are also connected to the wires 14 to cover the wires 14 (refer to FIGs. 6A to 6C). This structure also eliminates wire bonding and downsizes the optical waveguide board 6. In particular, the wires 14 made of aluminum (Al) have, on their surfaces, numerous irregularities resulting from alteration during manufacture. This produces an anchor effect to improve boding between the conductors. When the wires 14 each extend to the position overlapping the element mount area 21, the element mount area 21 overlapping the wires 14 is also likely to have irregularities on its surface. The electrodes 25 on the surface with the irregularities can be bonded more tightly.

The electrodes 25 are located at substantially the same level as the cores 17. The electrodes 25 are thus likely to receive light leaking from the cores 17. The electrodes 25 including conductors with a low reflectance can reduce leaking light reflected from the electrodes 25 and returning to the cores 17. In contrast, the wires 14 on the substrate 11 are less likely to receive light leaking from the cores 17. The wires 14 including the wide portions 14a with a higher reflectance can reduce ambient light entering the cores 17 through the substrate 11 and the cladding layer 12.

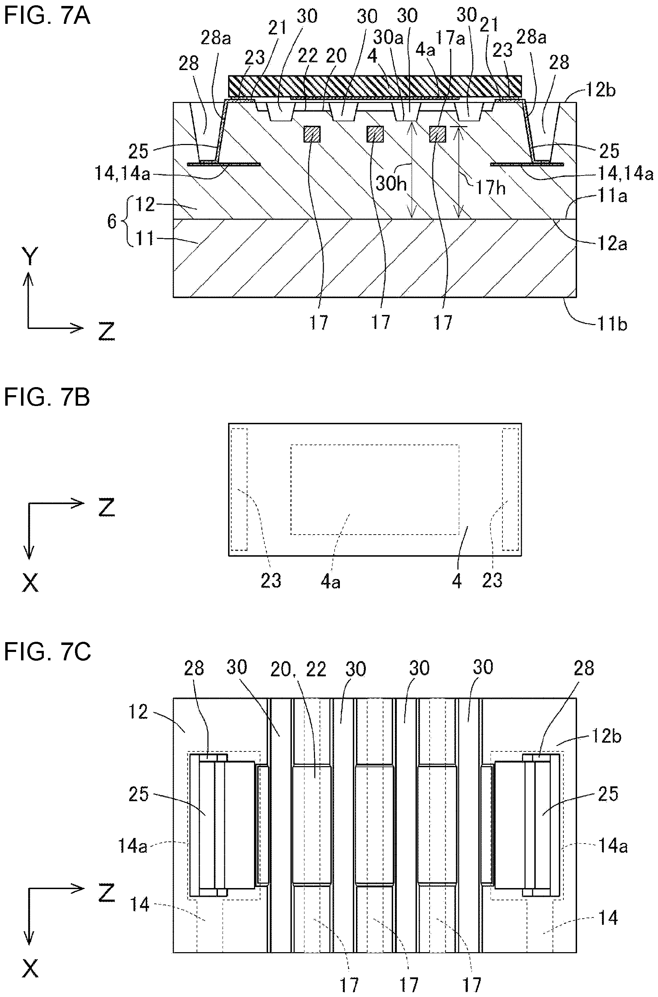

FIG. 7A is a cross-sectional view of a light receiver in a fourth embodiment, illustrating its structural arrangement. FIG. 7B is a plan view of the light receiver. FIG. 7C is a plan view of a cladding layer. Note that like reference numerals denote the corresponding parts of the structural arrangement of the light receiver in the first embodiment. In the structural arrangement of the light receiver in the fourth embodiment, as illustrated in FIGs. 7A to 7C, multiple second recesses 30 extend along the cores 17 on the second surface 12b of the cladding layer 12. The second recesses 30 are located with one of the three cores 17 between adjacent second recesses 30. The second recesses 30 each include a bottom surface 30a located at a higher level than the cores 17. In other words, a height 30h from the upper surface 11a of the substrate 11 to the bottom surface 30a of each of the second recesses 30 is greater than the height 17h from the substrate 11 to the upper surface 17a of each of the cores 17. The other components are the same as or similar to those in the third embodiment.

In the structural arrangement of the light receiver in the fourth embodiment, although the light receiver 4 deforms under heat, the second recesses 30 increase the gap between the optical waveguide board 6 and the light receiver 4 and also reduce deformation of the cladding layer 12 located between portions of the element mount area 21. This structure reduces the likelihood that the deformation affects the optical waveguide board 6. This reduces distortion of the cores 17, increasing the sensitivity of the light receiver 4. The bottom surfaces 30a of the second recesses 30 at a higher level than the cores 17 can reduce deformation of the core 17 and reduce variation in the gap.

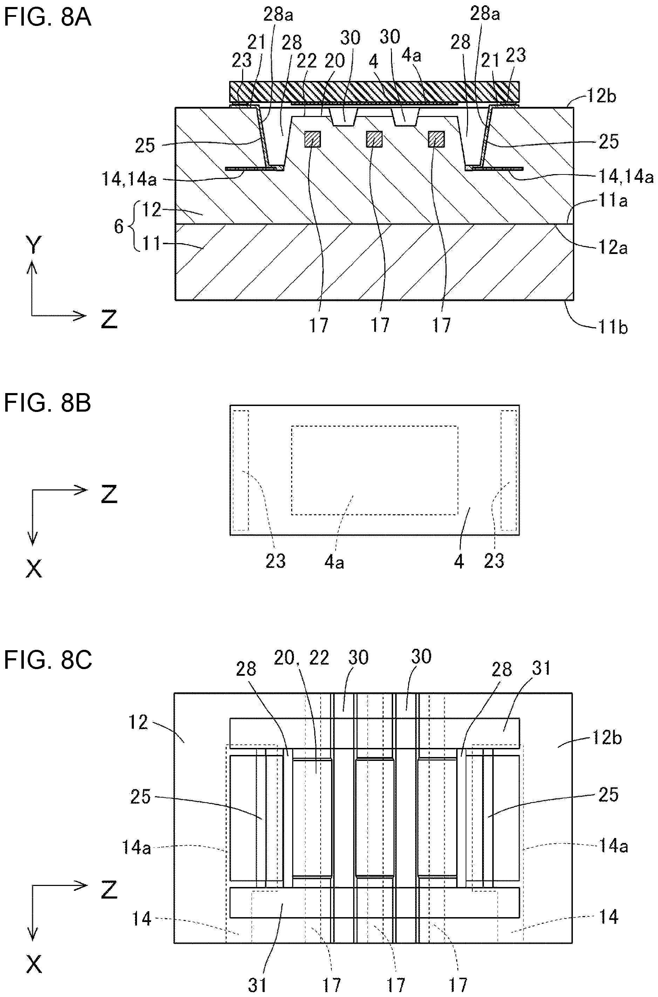

FIG. 8A is a cross-sectional view of a light receiver in a fifth embodiment, illustrating its structural arrangement. FIG. 8B is a plan view of the light receiver. FIG. 8C is a plan view of a cladding layer. Note that like reference numerals denote the corresponding parts of the structural arrangement of the light receiver in the first embodiment. In the structural arrangement of the light receiver in the fifth embodiment, as illustrated in FIGs. 8A to 8C, the first recesses 28 are located inward from the element mount area 21 and multiple second recesses 30 are located further inward from the first recesses 28. Light-shielding films 31 are located on two ends of the light receiver 4 in the X-direction. Each of the light-shielding films 31 extends between ends of the electrodes 25 covering the side surfaces 28a of the first recesses 28. The light-shielding films 31 are strip-shaped non-transmissive films that transmit no light. The light-shielding films 31 may be, for example, metal films of aluminum (Al). The other components are the same as or similar to those in the fourth embodiment. The light-shielding films 31 may be made of, for example, Ti, Cr, or Ni. The light-shielding films 31 may be located on the second surface 12b of the cladding layer 12 to surround portions of the cores 17 located between the portions of the element mount area 21 in a plan view, or in other words, to surround the light receiving area 20. In the example illustrated in FIGs. 8A to 8C, the light-shielding films 31 are located with the light receiving area 20 between them in the X-direction. The electrodes 25 are located with the light receiving area 20 between them in a Z-direction. The electrodes 25 are also light-shielding metal films. In other words, the light-shielding films 31 surround the light receiving area 20 in the example illustrated in FIGs. 8A to 8C.

In the structural arrangement of the light receiver in the fifth embodiment, the first recesses 28 are located inward from the element mount area 21. This structure reduces deformation of the cores 17 under stress (including thermal stress) generated between the optical waveguide board 6 and the light receiver 4. The light-shielding films 31 can also efficiently block ambient light incident around the light receiver 4 and into the light receiving part 4a. This increases the sensing accuracy of light leaking from the cores 17.

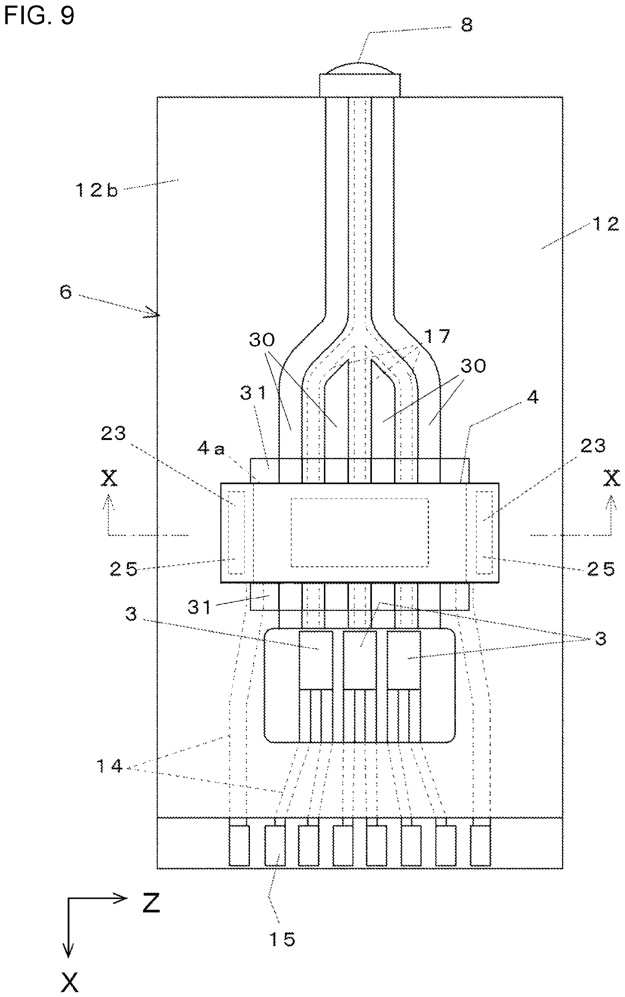

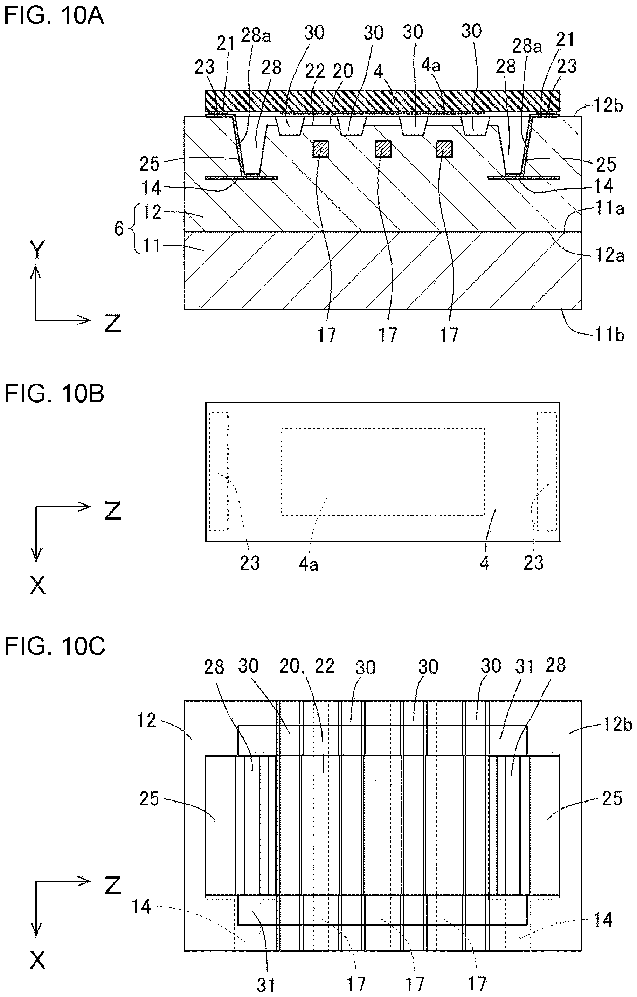

FIG. 9 is a plan view of an optical waveguide board, illustrating the structural arrangement of a light receiver in a sixth embodiment. FIG. 10A is a cross-sectional view taken along section line X-X in FIG. 9. FIG. 10B is a plan view of the light receiver. FIG. 10C is a plan view of a cladding layer. Note that like reference numerals denote the corresponding parts of the structural arrangement of the light receiver in the first embodiment. In this example, the light-shielding films 31 surround the element mount area 21 in cooperation with the electrodes 25. The other components and the effects are the same as or similar to those in the fifth embodiment. In this example, four second recesses 30 extend along the cores 17 on the second surface 12b of the cladding layer 12. The second recesses 30 are located with one of the three cores 17 between adjacent second recesses 30. Each of the first recesses 28 is located between the second recess 30 located outermost in the Z-direction of the four second recesses 30 and a portion of the element mount area 21. Note that, as illustrated in FIG. 9, the second recesses 30 may extend outside the light receiving area 20.

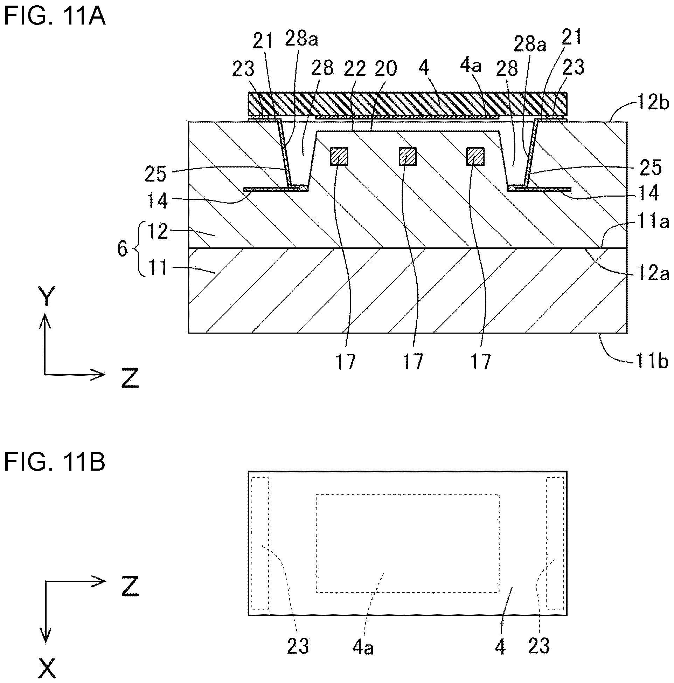

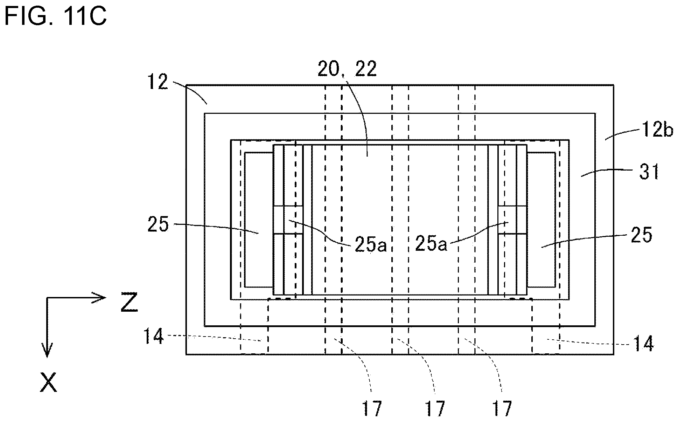

FIG. 11A is a cross-sectional view of a light receiver in a seventh embodiment, illustrating its structural arrangement. FIG. 11B is a plan view of the light receiver. FIG. 11C is a plan view of a cladding layer. Note that like reference numerals denote the corresponding parts of the structural arrangement of the light receiver in the first embodiment. In the structural arrangement of the light receiver in the seventh embodiment, as illustrated in FIGs. 11A to 11C, the electrodes 25 each include a narrow portion 25a partially covering the side surface 28a of the corresponding first recess 28. The light-shielding film 31 has a quadrangular loop shape to continuously surround the element mount area 21 in a plan view. The light-shielding film 31 may be made of, for example, Ti, Cr, or Ni.

In the second to sixth embodiments, the electrodes 25 entirely cover the side surfaces 28a of the first recesses 28. The electrodes 25 thus function as light-shielding films. In contrast, in the seventh embodiment, the narrow portions 25a of the electrodes 25 partially cover the side surfaces 28a of the first recesses 28. In this structure, the electrodes 25 do not function sufficiently as the light-shielding films. The loop-shaped light-shielding film 31 alone surrounds the element mount area 21 to reliably prevent ambient light from entering the light receiving part 4a.

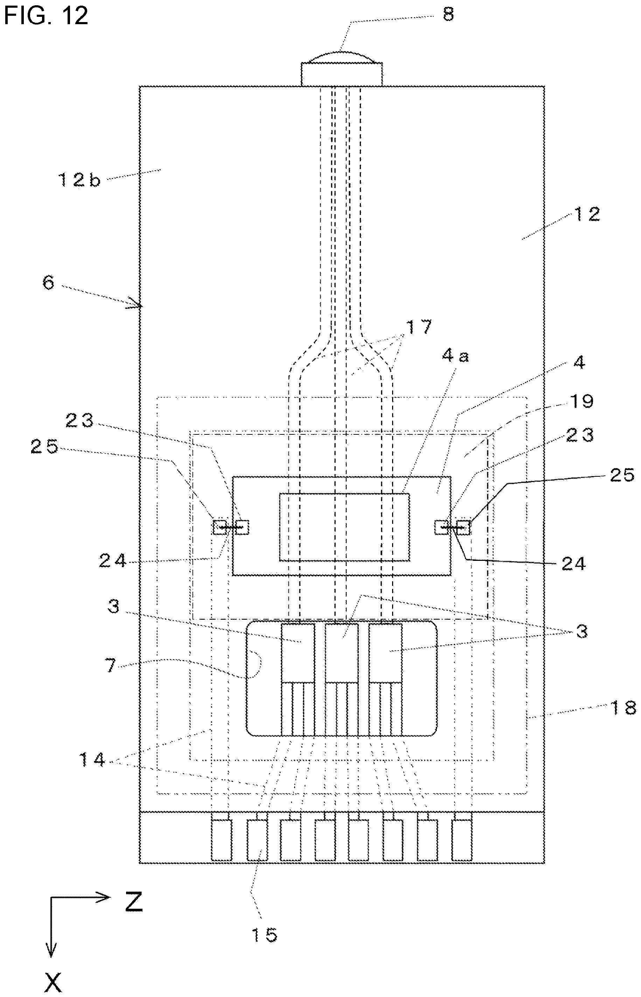

FIG. 12 is a plan view of a light source module according to another embodiment. Note that like reference numerals denote the corresponding components in the above embodiments. Such components will not be described repeatedly. In the above embodiments, the structure includes the merging portion in which the three cores 17 merge with one another into a single waveguide. The single waveguide then extends to the emission end. In the other embodiment illustrated in FIG. 12 as well, three incident ends of the cores 17 are spaced from one another to align with the respective light emitters 3 with the center of each of the incident ends matching an optical axis of the corresponding light emitter 3. In the above examples, the cores 17 bend and merge with one another or closer to one another outside the joint area 18. However, the cores 17 may each bend at a position adjacent to the incident end from the joint area 18 or at a position between the joint area 18 and the element mount area 21.

The three cores 17 include emission ends located closer to one another but separate from one another. In this manner, between the incident ends and the emission ends, the three cores 17 may converge closer to one another and then extend parallel to one another to the respective emission ends. The three cores 17 may not be parallel to one another and may be substantially parallel to one another at intervals decreasing toward the emission ends. The cores 17 may bend largely closer to one another and then extend at intervals decreasing to the emission ends. The cores 17 may bend greatly closer to one another and then extend substantially parallel to one another to the emission ends. In this structure, the cores 17 adjacent to one another may be at intervals decreasing from a portion in which the cores 17 are closer to one another to the emission ends. Light emitted through the emission ends of the respective cores 17 may be merged through, for example, the condenser lens 8. Light may be emitted from each of the cores 17 in a manner, for example, parallel to one another through the lens 8. In this case, images formed with light emitted through the three emission ends may be combined with, for example, an external device.

In one or more embodiments of the present disclosure, the optical waveguide board includes the cladding layer including, on the second surface, the element mount area on which the light receiver is mountable. The element mount area is located with the core between the portions of the element mount area in a plan view. The height from the substrate to the element mount area is greater than the height from the substrate to the upper surface of the area of the cladding layer covering the cores. This structure increases light sensitivity.

The optical waveguide board according to one or more embodiments of the present disclosure may have aspects (1) to (11) described below.
(1) An optical waveguide board, comprising:
   a substrate;
   a cladding layer on the substrate; and
   a core in the cladding layer, the core defining an optical waveguide,
   wherein the cladding layer includes a first surface facing the substrate and a second surface opposite to the first surface, and includes, on the second surface, an element mount area on which a light receiver is mountable, and the element mount area is located with the core between portions of the element mount area in a plan view, and
   a height from the substrate to the element mount area is greater than a height from the substrate to an upper surface of an area of the cladding layer covering the core.
(2) The optical waveguide board according to (1), wherein
   the cladding layer includes first recesses located with the core between the first recesses in a plan view.
(3) The optical waveguide board according to (1) or (2), further comprising:
   electrodes in the element mount area, the electrodes being electrically connectable to the light receiver being mounted.
(4) The optical waveguide board according to (2), further comprising:
   electrodes extending from the element mount area onto side surfaces of the first recesses.
(5) The optical waveguide board according to (4), wherein
   the side surfaces each have a greater surface roughness than the second surface.
(6) The optical waveguide board according to (4), wherein
   each of the side surfaces slopes to face more upward at a farther distance from an upper surface of the substrate.
(7) The optical waveguide board according to any one of (2) to (6), further comprising:
   one or more cores in the cladding layer, the one or more cores defining optical waveguides,
   wherein the cladding layer includes second recesses located with the one or more cores between the second recesses.
(8) The optical waveguide board according to (7), wherein
   a height from the substrate to a bottom surface of each of the second recesses is greater than a height from the substrate to each of the one or more cores.
(9) The optical waveguide board according to (4), further comprising:
   wires on bottom surfaces of the first recesses, the wires each having a higher light reflectance than the electrodes.
(10) The optical waveguide board according to (9), wherein
   the wires extend to positions overlapping the element mount area in a plan view.
(11) The optical waveguide board according to any one of (1) to (10), further comprising:
   a light-shielding film on the second surface of the cladding layer, the light-shielding film surrounding a portion of the core located between the portions of the element mount area in a plan view.
   The optical waveguide package according to one or more embodiments of the present disclosure may have aspects (12) and (13) described below.
(12) An optical waveguide package, comprising:
   the optical waveguide board according to any one of (1) to (11); and
   a light receiver mounted on the element mount area, the light receiver including a light receiving part at a position overlapping the core in a plan view.
(13) The optical waveguide package according to (12), wherein
   the light receiver is mounted with the light receiving part facing the optical waveguide board.
   The optical waveguide package according to one or more embodiments of the present disclosure may have aspect (14) described below.
(14) A light source module, comprising:
   the optical waveguide package according to (12) or (13);
   a light emitter optically coupled to the light receiver with the core; and
   a lid covering the light receiver and the light emitter.

Although embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

- 1: light source module
- 2: optical waveguide package
- 3: light emitter
- 4: light receiver
- 4a: light receiving part
- 5: lid
- 6: optical waveguide board
- 11: substrate
- 12: cladding layer
- 12a: lower surface (first surface)
- 12b: upper surface (second surface)
- 14: wire
- 17: core
- 20: light receiving area
- 20h: height of light receiving area
- 21: element mount area
- 21h: height of element mount area
- 25: electrode
- 28: first recess
- 28a: side surface (of first recess)
- 30: second recess
- 30a: bottom surface (of second recess)
- 31: light-shielding film

## Claims

1. An optical waveguide board, comprising:
a substrate;
a cladding layer on the substrate; and
a core in the cladding layer, the core defining an optical waveguide,
wherein the cladding layer includes a first surface facing the substrate and a second surface opposite to the first surface, and includes, on the second surface, an element mount area on which a light receiver is mountable, and the element mount area is located with the core between portions of the element mount area in a plan view, and
a height from the substrate to the element mount area is greater than a height from the substrate to an upper surface of an area of the cladding layer covering the core.

2. The optical waveguide board according to claim 1, wherein
the cladding layer includes first recesses located with the core between the first recesses in a plan view.

3. The optical waveguide board according to claim 1 or claim 2, further comprising:
electrodes in the element mount area, the electrodes being electrically connectable to the light receiver being mounted.

4. The optical waveguide board according to claim 2, further comprising:
electrodes extending from the element mount area onto side surfaces of the first recesses.

5. The optical waveguide board according to claim 4, wherein
the side surfaces each have a greater surface roughness than the second surface.

6. The optical waveguide board according to claim 4, wherein
each of the side surfaces slopes to face more upward at a farther distance from an upper surface of the substrate.

7. The optical waveguide board according to any one of claims 2 to 6, further comprising:
one or more cores in the cladding layer, the one or more cores defining optical waveguides,
wherein the cladding layer includes second recesses located with the one or more cores between the second recesses.

8. The optical waveguide board according to claim 7, wherein
a height from the substrate to a bottom surface of each of the second recesses is greater than a height from the substrate to each of the one or more cores.

9. The optical waveguide board according to claim 4, further comprising:
wires on bottom surfaces of the first recesses, the wires each having a higher light reflectance than the electrodes.

10. The optical waveguide board according to claim 9, wherein
the wires extend to positions overlapping the element mount area in a plan view.

11. The optical waveguide board according to any one of claims 1 to 10, further comprising:
a light-shielding film on the second surface of the cladding layer, the light-shielding film surrounding a portion of the core located between the portions of the element mount area in a plan view.

12. An optical waveguide package, comprising:
the optical waveguide board according to any one of claims 1 to 11; and
a light receiver mounted on the element mount area, the light receiver including a light receiving part at a position overlapping the core in a plan view.

13. The optical waveguide package according to claim 12, wherein
the light receiver is mounted with the light receiving part facing the optical waveguide board.

14. Alight source module, comprising:
the optical waveguide package according to claim 12 or claim 13;
a light emitter optically coupled to the light receiver with the core; and
a lid covering the light receiver and the light emitter.
